# EUROPEAN PATENT APPLICATION

(11) **EP 4 373 134 A1**
(43) Date of publication of application: **22.05.2024**
(21) Application number: 22841676.4
(22) Date of filing: 02.03.2022
(51) Int. Cl.: H04R 3/04, H03G 5/16

(54) **INFORMATION PROCESSING DEVICE, INFORMATION PROCESSING METHOD, AND PROGRAM**

(30) Priority: 15.07.2021 JP 2021116815
(71) Applicant: Sony Group Corporation, Tokyo 108-0075 (JP)
(72) Inventor: OSAKO, Keiichi, Tokyo 108-0075 (JP); MATSUI, Takeshi, Tokyo 108-0075 (JP); HAYASHI, Hiroaki, Tokyo 108-0075 (JP); FUKUI, Takao, Tokyo 108-0075 (JP)
(74) Representative: 2SPL Patentanwälte PartG mbB
(86) International application number: PCT/JP2022/008820
(87) International publication number: WO 2023/286326

(57) **Abstract**

For example, it becomes possible to suppress an increase in hardware scale and costs and to perform signal processing according to an input signal.

Provided is an information processing apparatus including a filter processing unit that performs filtering on an input signal, and a filter setting unit that makes a setting of the filtering such that a sound of a target audio source type in the input signal is controlled and the setting is determined using an estimation result obtained from the input signal by an estimation algorithm.

## Description

### TECHNICAL FIELD

The present disclosure relates to an information processing apparatus, an information processing method, and a program.

### BACKGROUND ART

When allowing a user to listen to audio signals of music, a game, a voice call, or the like, it becomes possible to control sound to be listened by introducing signal processing such as an equalizer or noise filtering.

For example, at a time of game play, it may be desired to make it easy to hear sound necessary for game operation, such as a gunshot sound and a footstep sound included in reproduced sound of the game. In this case, it becomes possible to easily listen to the target sound by amplifying or attenuating a specific frequency band of the sound to be listened to. For example, it becomes possible to emphasize the gunshot sound to make it easy to listen to by amplifying the frequency band in which the gunshot sound is included or by attenuating the frequency band in which no gunshot sound is included.

Furthermore, in a voice call, for example, noise other than a desired sound (e.g., interaction sound) such as an air-conditioning sound or electric noise may be mixed to make it difficult to listen to the desired sound. In this case, by attenuating the frequency band of the noise, for example, it becomes possible to remove the noise to make it easy to listen to.

In order to achieve such sound control, currently, a sound control function such as an equalizer is appropriately adjusted manually or by presetting according to a sound that the user wants to listen to or does not want to listen to, for example. However, this adjustment is complex, or it is difficult to operate without a sense of pitch.

Meanwhile, Patent Document 1 set out below proposes a technique of automatically controlling sound (specifically, context-based ambient sound enhancement and acoustic noise canceling technique). The technique disclosed in Patent Document 1 adds amplified or attenuated surrounding signals to acoustic noise canceling signals, which is targeted for a noise-canceling headphone. Specifically, this processing is achieved by a combination of the acoustic noise canceling technique and a filter that modulates the frequency of the ambient sound.

### CITATION LIST

### PATENT DOCUMENT

Patent Document 1: Japanese Patent Application Laid-Open No. 2020-197712

### SUMMARY OF THE INVENTION

### PROBLEMS TO BE SOLVED BY THE INVENTION

However, since the technique disclosed in Patent Document 1 requires a microphone to obtain the ambient sound, there is a problem that a hardware scale and costs increase. Furthermore, basically, only the sound around the user may be controlled, and only signal processing such as a predetermined equalizer is performed on input (reproduction) signals of a game, a voice call, or the like, for example. Therefore, the sound may not be controlled according to the input signals.

An object of the present disclosure is to provide an information processing apparatus, an information processing method, and a program capable of performing processing according to an input signal while suppressing an increase in hardware scale and costs.

### SOLUTIONS TO PROBLEMS

For example, the present disclosure is directed to:
an information processing apparatus including:
a filter processing unit that performs filtering on an input signal; and
a filter setting unit that makes a setting of the filtering such that a sound of a target audio source type in the input signal is controlled and the setting is determined using an estimation result obtained from the input signal by an estimation algorithm.

For example, the present disclosure is directed to:
an information processing method including:
determining a setting of filtering of a filter processing unit that performs the filtering on an input signal using an estimation result obtained from the input signal by an estimation algorithm to control a sound of a target audio source type in the input signal.

For example, the present disclosure is directed to:
a program for causing a computer to perform a process including:
determining a setting of filtering of a filter processing unit that performs the filtering on an input signal using an estimation result obtained from the input signal by an estimation algorithm to control a sound of a target audio source type in the input signal.

### BRIEF DESCRIPTION OF DRAWINGS

Fig. 1 is a block diagram illustrating a configuration example of a commonly used equalizer.
Fig. 2 is a diagram illustrating exemplary display of a setting instruction screen for sound quality adjustment.
Fig. 3 is a diagram illustrating exemplary display of an updated equalizer.
Fig. 4 is a diagram illustrating a configuration example of functional blocks of an information processing apparatus.
Fig. 5 is a diagram illustrating exemplary audio source separation by a neural network.
Fig. 6 is a diagram illustrating a hardware configuration example of the information processing apparatus.
Fig. 7 is a flowchart illustrating an example of a process performed by the information processing apparatus.
Fig. 8 is a flowchart illustrating an example of a filter coefficient calculation process.
Fig. 9 is a diagram illustrating a configuration example of other functional blocks of the information processing apparatus.
Fig. 10 is a diagram illustrating an example of filter coefficient calculation by the neural network.
Fig. 11 is a diagram illustrating a configuration example of other functional blocks of the information processing apparatus.
Fig. 12 is a diagram illustrating a configuration example of other functional blocks of the information processing apparatus.

### MODE FOR CARRYING OUT THE INVENTION

Hereinafter, embodiments and the like of the present disclosure will be described with reference to the drawings. Note that the description will be given in the following order.

### <1. Background>

### <2. First Embodiment>

### <3. Second Embodiment>

### <4. Third Embodiment>

### <5. Fourth Embodiment>

### <6. Variations>

Embodiments and the like to be described below are preferred specific examples of the present disclosure, and the content of the present disclosure is not limited to those embodiments and the like. Note that, in the following description, components having substantially the same functional configuration are denoted by the same reference sign, and redundant description will be omitted as appropriate.

### <1. Background>

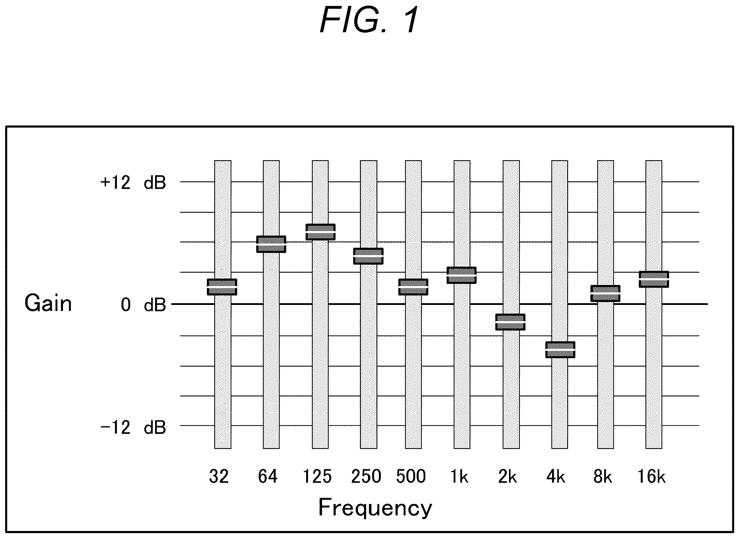

First, a background of the present disclosure will be described. Fig. 1 illustrates a configuration example of a commonly used equalizer. For example, a user may adjust the gain (specifically, gain value) of each frequency band of the equalizer by a knob operation or the like according to a sound that the user wants to listen to or does not want to listen to. An infinite impulse response (IIR) filter or a finite impulse response (FIR) filter is commonly used as internal signal processing. In particular, in a case of using the IIR filter, a delay time from an input to an output is approximately several hundred microseconds to several milliseconds, and thus no sensible sound delay is felt. Accordingly, since sound quality may be adjusted in real time, it is widely used in applications in which real-time property is important, such as games and voice calls.

However, in the sound quality adjustment using the equalizer, fine adjustment of the gain value of each frequency band is complex, and moreover, it is difficult to operate without a sense of pitch under current conditions. The existing technique effective to that issue and its problems are as described above in the background art.

Meanwhile, in recent years, it has become possible to remove or extract a specific sound included in audio signals using artificial intelligence (AI) technology. For example, as disclosed in Non-Patent Document 1 set out below, a technique has been known in which a neural network that separates a predetermined target sound is trained and constructed to achieve audio source separation using the trained neural network. Using this technique, it becomes possible to separate any and all sounds from the input signals so that the desired sound may be directly listened to.

Non-Patent Document 1: Stefan Uhlich others. "Improving music source separation based on deep neural networks through data augmentation and network blending." 2017 IEEE International Conference on Acoustics, Speech and Signal Processing (ICASSP 2017). 2017.

However, according to the technique disclosed in Non-Patent Document 1, it is necessary to buffer the input signals for several tens of milliseconds to several hundreds of milliseconds due to the structure of the neural network, which means that a delay occurs in output signals. Accordingly, in the applications in which real-time property is important as described above, for example, this delay becomes a problem, and thus it has not been possible to use the audio source separation technique based on the neural network.

In view of the above, the present disclosure solves those problems and automatically takes optimum sound control so that the user is not required to finely adjust the equalizer, and moreover, the output may be performed with a low delay.

### <2. First Embodiment>

### [2-1. Specific Example of Application]

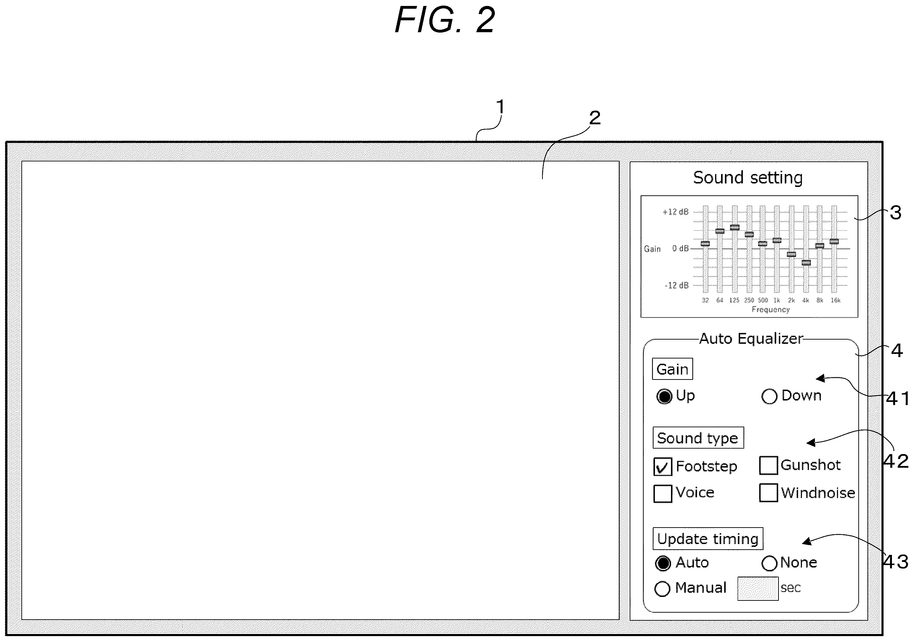

First, a specific example of an application according a first embodiment will be described. Note that an exemplary case where sound quality adjustment of game reproduction sound is performed will be described in the present embodiment. Fig. 2 illustrates exemplary display of a setting instruction screen for sound quality adjustment. In the illustrated example, a sound quality adjustment function is incorporated in a screen during a game. With this arrangement, sound quality adjustment may be performed during the game, for example.

Specifically, in a display screen 1, a game screen 2 is displayed on the left side, and an equalizer 3 is displayed on the right side. The equalizer 3 is of a type commonly used as described above. A user may adjust sound quality of output signals of the game by operating the equalizer 3. Specifically, the user may adjust the gain (gain value) of each frequency band of the equalizer 3 by a knob operation (operation of moving a knob position) or the like according to a sound that the user wants to listen to or does not want to listen to.

Furthermore, on the lower side of the equalizer 3, a user instruction input unit 4 (part displayed as "Auto Equalizer") for automatically adjusting the equalizer 3 (specifically, internal frequency modulation filter) is displayed. In the drawing, a portion displayed as "Gain" is a gain setting unit 41 that allows the user to make an instruction regarding gain setting. Specifically, the gain setting unit 41 causes the user to specify whether to amplify or attenuate a sound of a target audio source type specified by "Sound type" to be described later. For example, "Up (amplification)" is selected in a case where the sound that the user wants to listen to is specified by the "Sound type", and "Down (attenuation)" is selected in a case where the sound that the user does not want to listen to is specified. Note that the function of the gain setting unit 41 is not limited to simply allowing the user to select amplification or attenuation, and may be setting a level of amplification or attenuation, such as +o dB or -o dB ("o" represents a predetermined numerical value).

A portion displayed as "Sound type" is a target audio source specifying unit 42 that allows the user to specify a target audio source type. The target audio source type mentioned here indicates, for example, a type of the sound that the user wants to control. Specifically, the target audio source specifying unit 42 allows the user to select a type of the sound that the user wants to listen to or does not want to listen to. As a target audio source type, for example, various categories may be prepared such as a case where it is desired to amplify and listen to a sound of "Footstep" or "Gunshot" in the game, and a case where it is desired to attenuate "Wind noise". One or two or more "Sound types" may be selected.

Here, a combination of "Gain" with "Sound type" is described as one set in this example, and only one of amplification and attenuation is selected. Depending on the user, a combination such as footstep amplification and wind noise attenuation may occur, and thus two or more sets of setting items may be provided to enable those settings.

A portion displayed as "Update timing" is a coefficient update setting unit 43 that allows the user to specify a coefficient update setting. Specifically, the coefficient update setting unit 43 allows the user to specify timing (time, interval, etc.) at which automatic adjustment of the sound quality is carried out. For example, when an "Auto" mode is selected, the equalizer 3 is adjusted in a section with no game sound, at a moment of switching a scene, or the like. With this arrangement, the equalizer 3 may be changed without discomfort with respect to the game sound that the user is listening to with concentration, and thus immersive feeling is not impaired.

Furthermore, when a "None" mode is designated, the equalizer 3 is updated immediately after the "Gain" or "Sound type" described above is specified (after the setting is changed). That is, it becomes possible to immediately change the sound quality in response to user operation. Furthermore, when a "Manual" mode is selected, the equalizer 3 is periodically updated according to a specified interval time. With this arrangement, it becomes possible to meet the user's desire to constantly and continuously update the equalizer 3. For example, a numerical value such as every 0.5 seconds or every 2 seconds may be set. Various types of setting information specified by the user instruction input unit 4 are stored in a storage area in a readable manner, for example.

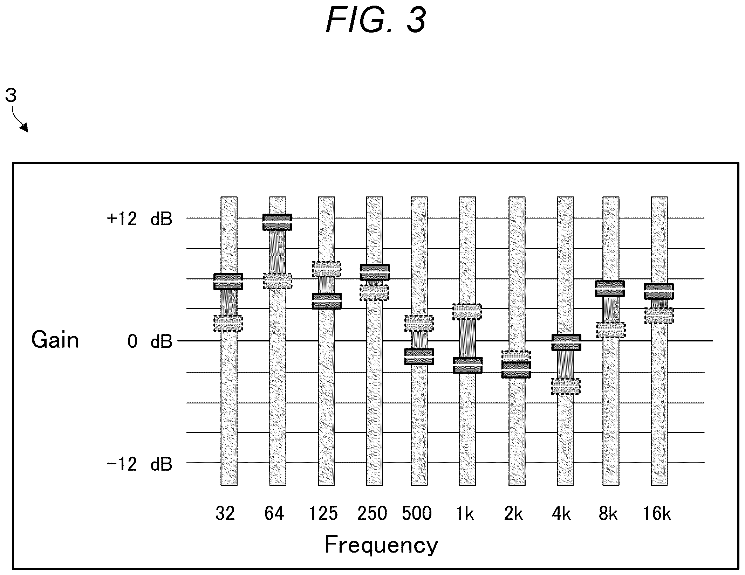

Specifically, the present application uses audio signals of the game reproduction sound as input signals, performs signal processing (specifically, filtering) on the input signals according to the setting specified by the user instruction input unit 4, and enables the user to listen to output signals thereof. Furthermore, in a case where the setting of the signal processing is updated, an image showing a difference between before and after the update is caused to be displayed on a display device. For example, as illustrated in Fig. 3, the gain and the knob position that have changed for each frequency band are color-coded and displayed in a discriminable manner. Note that a difference in color is expressed by shading in the example illustrated in Fig. 3. Specifically, a knob of a light color represents a knob position before the update, and a knob of a dark color represents a knob position after the update, that is, the current knob position. With this arrangement, the user is enabled to easily grasp that the equalizer has changed (including the change content). Note that a notation indicating a setting, such as "footstep amplification", may be added so that the setting of the equalizer may be recognized at a glance.

### [2-2. Configuration Example of Information Processing Apparatus]

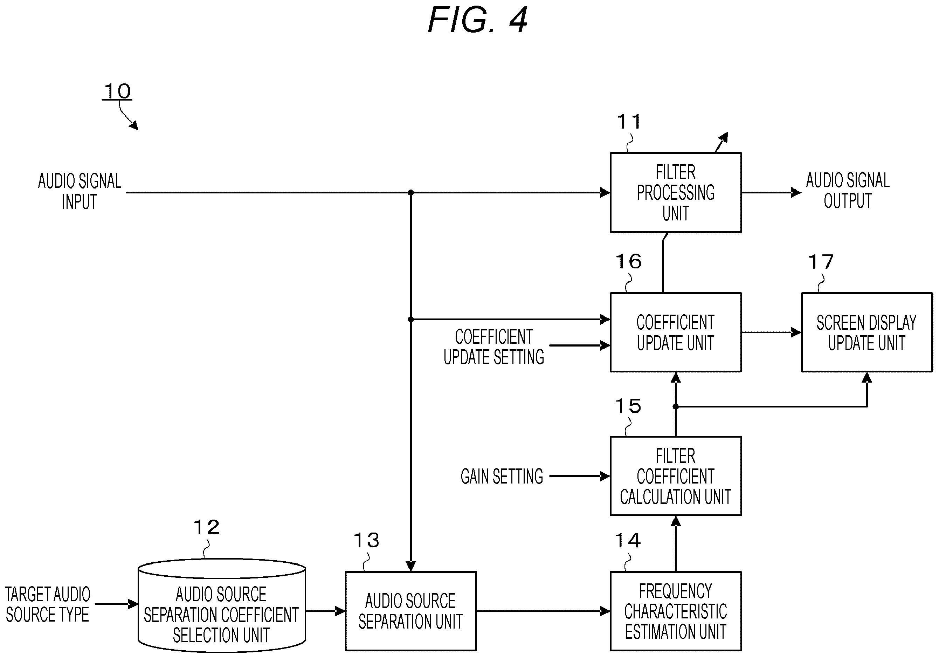

Fig. 4 illustrates a configuration example of functional blocks of an information processing apparatus (information processing apparatus 10) according to the first embodiment. The information processing apparatus 10 implements, for example, a signal processing circuit applicable to the application described above (specifically, reproduction signals). The information processing apparatus 10 performs signal processing on input signals (specifically, audio signals) to control sound. The audio signals are obtained from an application of, for example, the above-described game, voice call (e.g., web conferencing system), or the like. The information processing apparatus 10 may include various electronic devices (specifically, computer devices) that handle audio signals, such as a personal computer, a smartphone, a tablet terminal, a game machine, a speaker device, a headphone, earphones, a smart appliance, a television, a player, a recorder, a telephone, an in-vehicle unit, a monitoring device, or a medical device.

The information processing apparatus 10 includes a filter processing unit 11, an audio source separation coefficient selection unit 12, an audio source separation unit 13, a frequency characteristic estimation unit 14, a filter coefficient calculation unit 15, a coefficient update unit 16, and a screen display update unit 17, and performs signal processing according to the setting described above.

The filter processing unit 11 filters and outputs input signals (specifically, input audio signals). With this arrangement, for example, the frequency characteristics of the output signals (specifically, audio signals after the filtering) are changed. Specifically, the filter processing unit 11 includes a filter circuit (frequency modulation filter), and the filtering is carried out using this filter circuit. For example, this filter circuit may be implemented by the IIR filter or the FIR filter described above. That is, the filtering may be carried out using the IIR filter or the FIR filter. Note that the filter circuit that performs the filtering is not limited to this, and may be, for example, a filter that performs a process of carrying out a fast Fourier transform (FFT), amplifying or attenuating the gain of the amplitude spectrum of the signal converted into the frequency domain, and carrying out an inverse fast Fourier transform (IFFT) to return the signal to the time-domain waveform.

In the present embodiment, specifically, the IIR filter is assumed to perform low-delay processing. With this arrangement, the filtering may be carried out as real-time processing, and may be applied to an application in which real-time property is important as described above, that is, the real-time processing without any problem. Note that the real-time processing may be performed even with a filter other than the IIR filter as long as low-delay processing not sensible to the user is possible.

An initial value of the filtering setting (specifically, filter coefficient) may have a flat frequency characteristic, that is, a property that the input signal is directly output. Alternatively, the previously used coefficient may be retained and used again in the same setting. In this manner, an appropriately determined initial value of the filtering setting may be used. An output signal output from the filter processing unit 11 is output to another signal processing module coupled at a subsequent stage, an output (reproduction) device such as a speaker or a headphone, or the like.

The audio source separation coefficient selection unit 12 and the audio source separation unit 13 perform processing related to audio source separation. The audio source separation coefficient selection unit 12 selects an audio source separation coefficient on the basis of the set target audio source type. The target audio source type is, for example, one specified as described above (sound category such as "Footstep" or "Gunshot"), which is input to the audio source separation coefficient selection unit 12 as textual information or a numerical parameter.

Specifically, the audio source separation coefficient selection unit 12 saves a coefficient group necessary for the audio source separation processing in the audio source separation unit 13 in a storage area such as a hard disk drive (HDD) in advance, loads the corresponding coefficient on the basis of the specified target audio source type, and transmits it to the audio source separation unit 13. Specifically, this coefficient group needs to be prepared for the number of categories of sounds to be separated and controlled by the audio source separation. In other words, as long as this audio source separation coefficient is prepared, any and all sounds may be separated and controlled. Therefore, in a case where a new sound category appears, a coefficient thereof may be additionally recorded here to handle it.

The audio source separation unit 13 executes the audio source separation processing. An estimation algorithm regarding the audio source separation is used for the audio source separation processing. Specifically, this estimation algorithm estimates and separates the sound of the specified target audio source type from the input signals (specifically, input audio signals), and outputs the separated sound as an estimation result. As the estimation algorithm, for example, a method based on a neural network (specifically, the method disclosed in Non-Patent Document 1 mentioned above) may be adopted. For example, in a case of training the target audio source type "Footstep" using the neural network, a large number (e.g., 100,000 to 1,000,000) of input signals for the training of "Footstep" are used to carry out training of separating the sound of "Footstep" from each of the input signals. In this case, the parameters of the neural network after the training are saved as coefficients (coefficients to be loaded by the audio source separation coefficient selection unit 12) necessary for separating the audio source of "Footstep" in the audio source separation unit 13.

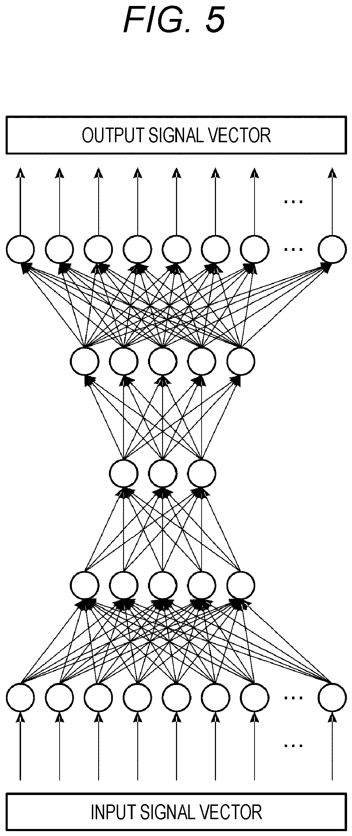

Fig. 5 illustrates exemplary audio source separation based on the neural network. In the present process, first, an input signal including a signal to be separated is subject to frequency conversion, and an amplitude spectrum thereof is set as an input signal vector. Since the vector size depends on the conversion length of the frequency conversion, it is 1,024, 2,048, or the like, for example. This vector is input to the neural network, and an output signal vector as an estimation result is obtained through internal processing using the coefficient transmitted from the audio source separation coefficient selection unit 12. This output signal vector is an amplitude spectrum of the separated signal. This process is performed on the input signal data at regular intervals (framing processing), thereby obtaining an amplitude spectrum of the separated signal in each frame. The amplitude spectrum of the separated signal, that is, the estimation result based on the estimation algorithm is output to the frequency characteristic estimation unit 14 illustrated in Fig. 4.

As described above, the audio source separation based on the neural network may separate a desired sound highly accurately even though a delay of several tens of milliseconds to several hundreds of milliseconds occurs. The sound of the target audio source type included in the input signals may change in the frequency characteristics. That is, it becomes possible to accurately separate the sound of the target audio source type that may change according to the input signal. For example, in a case where "Footstep" is specified as the target audio source type, the footstep sound may be appropriately separated even in the case where the footstep sound of walking on asphalt is changed to the footstep sound of walking on grass.

Note that the estimation algorithm is not limited to one using the method based on the neural network as disclosed in Non-Patent Document 1. Any method may be used as long as it is a method of extracting a sound of a target audio source type, and for example, it may be a method using non-negative matrix factorization (NMF). As described above, in the case of using another estimation algorithm as well, a desired sound may be separated highly accurately even though a delay may occur in a similar manner.

The frequency characteristic estimation unit 14 illustrated in Fig. 4 estimates frequency characteristics. This estimation uses the amplitude spectrum of the separation signal input from the audio source separation unit 13, that is, the amplitude spectrum of the sound of the category specified by the user in advance. Specifically, since the amplitude spectrum is sequentially input for each frame, the frequency characteristic of the desired sound may be estimated by, for example, calculating a weighted sum with weight of an average or a time constant. Here, there may be both a section in which the desired sound is produced like "Footstep" and a silent section. In that case, since an error may occur when the silent section is included in the average calculation, it may be determined as a silent section in a case of equal to or lower than a certain threshold and excluded from the average calculation. Note that the frequency characteristic estimation unit 14 is not limited to this, and the frequency characteristic may be estimated by another method.

The filter coefficient calculation unit 15 calculates a filter coefficient to be used in the filter processing unit 11. Specifically, the filter coefficient calculation unit 15 first reads the gain setting set by the user. As described above, this may be set by the setting of whether to amplify or attenuate the sound of the specified target audio source type or a specific numerical value such as +o dB or -o dB. In this manner, the filter coefficient calculation unit 15 sets the filter coefficient that controls the sound of the target audio source type included in the input signal. Specifically, the filter coefficient calculation unit 15 determines a target filter characteristic on the basis of the gain setting and the frequency characteristic estimated by the frequency characteristic estimation unit 14. It is sufficient if, after the determination of the characteristic, a coefficient conforming to the format (e.g., IIR filter, FIR filter, etc.) used by the filter processing unit 11 is calculated. This calculation may use any algorithm such as a classical method of obtaining from a transfer function or a method based on numerical optimization. Specifically, the filter coefficient calculated in this manner amplifies or attenuates each frequency band of the input signals as appropriate so that the sound of the target audio source type is amplified or attenuated. The calculated coefficient is output to the coefficient update unit 16 and the screen display update unit 17.

The coefficient update unit 16 is a filter setting unit that performs filtering setting in the filter processing unit 11. Specifically, the coefficient update unit 16 sets the setting of the filter coefficient in the filter processing unit 11 as the coefficient input from the filter coefficient calculation unit 15. That is, as described above, it is set to control the sound of the target audio source type in the input signals and to be determined using the estimation result obtained from the input signals by the estimation algorithm.

Here, the coefficient update unit 16 controls the timing of the filter coefficient update on the basis of the coefficient update setting set by the user. The coefficient update unit 16 detects the timing on the basis of, for example, the input signals (specifically, input audio signals). Here, it should be noted that the filter processing unit 11 continues to filter and output the input signals at all times, specifically, with a low delay of several hundred microseconds to several milliseconds. That is, the filtering in the filter processing unit 11 is processing (specifically, real-time processing) with a lower delay than at least the estimation algorithm. That is, the user does not feel a delay, and is in a state of listening to the output sound of the equalizer as in a conventional manner. In this manner, by updating only the filter coefficient, it becomes possible to achieve highly accurate filtering for controlling (specifically, amplifying or attenuating frequency characteristics of) the sound specified by the target audio source type while maintaining a low delay.

Specifically, as described with reference to Fig. 2, the coefficient update unit 16 updates the filter coefficient at the timing when the user changes the coefficient setting (specifically, setting of "Gain" or "Sound type" described above) and a filtering instruction is newly received in a case where the coefficient update setting is "None". Furthermore, in a case where the coefficient update setting is "Manual", the coefficient update unit 16 updates the filter coefficient at regular intervals according to the user setting or the like. Moreover, in a case where the coefficient update setting is "Auto", the coefficient update unit 16 updates the filter coefficient at timing that does not give the user discomfort.

Whether or not the timing gives discomfort is determined using predetermined determination information (e.g., audio signal, video signal, etc.) that indicates sound switching timing. For example, input signals are monitored as the determination information, and it may be changed at the timing when the volume (amplitude value) becomes smaller than a certain threshold. Alternatively, in a case of a game or music, it may be changed at a sound change part when a scene changes. With this arrangement, it becomes possible to avoid a sudden sound change due to a filter coefficient change. Note that, in a case where the filter coefficient is updated, the coefficient update unit 16 outputs information indicating the update to the screen display update unit 17.

The screen display update unit 17 updates the already displayed equalizer 3, filter setting parameters, and the like to the latest ones. Specifically, in a case where the coefficient update unit 16 updates the filter coefficient, that is, in a case where information indicating that the update is carried out is input from the coefficient update unit 16, the screen display update unit 17 causes the display device to output information indicating a difference between before and after the update. Specifically, as illustrated in Fig. 3, the screen display update unit 17 causes the display device to display an image of the equalizer 3, which may be operated by the user, including the information indicating the difference. Note that the information indicating the difference is not limited to the illustration in Fig. 3, and for example, it may be output from a reproduction device other than the display device (specifically, output from a speaker or the like as a sound).

### [2-3. Hardware Configuration Example of Information Processing Apparatus]

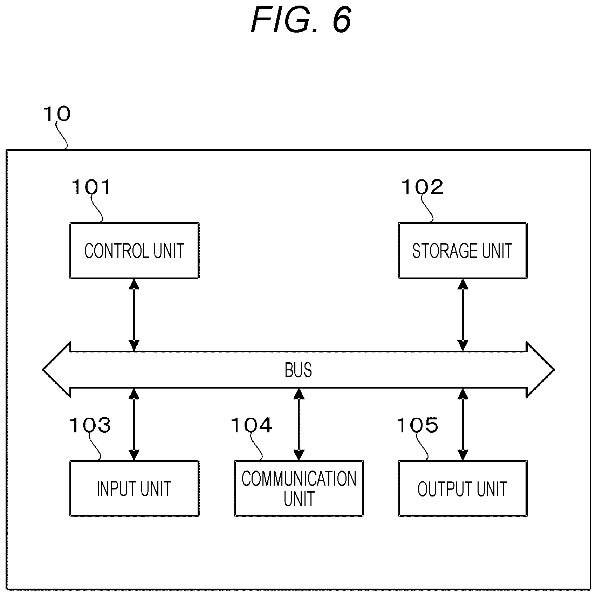

Fig. 6 illustrates a hardware configuration example of the information processing apparatus 10. The information processing apparatus 10 includes a control unit 101, a storage unit 102, an input unit 103, a communication unit 104, and an output unit 105, which are coupled to each other by a bus.

The control unit 101 includes, for example, a central processing unit (CPU), a random access memory (RAM), a read only memory (ROM), and the like. The ROM stores programs to be read and operated by the CPU, and the like. The R_AM is used as a work memory of the CPU. The CPU controls the entire information processing apparatus 10 by executing various processes according to a program stored in the ROM and issuing commands.

The storage unit 102 is a storage medium including, for example, an HDD, a solid state drive (SSD), a semiconductor memory, or the like, and stores content data such as image data, video data, audio data, text data, and moreover, data of a program (e.g., application), and the like.

The input unit 103 is a device for inputting various types of information to the information processing apparatus 10. When the input unit 103 inputs information, the control unit 101 performs various types of processing according to the input information. The input unit 103 may be, in addition to a mouse and a keyboard, a microphone, various sensors, a touch panel, a touch screen integrally configured with a monitor, a physical button, or the like. Note that the various types of information may be input to the information processing apparatus 10 via the communication unit 104 to be described later.

The communication unit 104 is a communication module that communicates with other devices and the Internet according to a predetermined communication standard. Examples of a communication scheme include a wireless local area network (LAN) such as Wireless Fidelity (Wi-Fi), Long Term Evolution (LTE), 5th generation mobile communication system (5G), broadband, Bluetooth (registered trademark), and the like.

The output unit 105 is a device for outputting various types of information from the information processing apparatus 10. The output unit 105 includes, for example, a display (display device) that displays an image and video, and an output device that outputs sound, such as a speaker. Note that the various types of information may be output from the information processing apparatus 10 via the communication unit 104.

The control unit 101 performs various types of processing by, for example, reading and executing a program (e.g., application) stored in the storage unit 102. That is, the information processing apparatus 10 has a function as a computer.

Note that the program (e.g., application) may not be stored in the storage unit 102. For example, a program stored in a storage medium readable by the information processing apparatus 10 may be read and executed. Examples of the storage medium include an optical disk, a magnetic disk, a semiconductor memory, an HDD detachable from the information processing apparatus 10, and the like. Furthermore, a program (e.g., application) or data may be stored in a device (e.g., cloud storage) connected to a network such as the Internet, and the information processing apparatus 10 may read the program or data therefrom to execute it. Furthermore, the program may be, for example, a plug-in program that adds a part or all of processing to an existing application. For example, the program may execute the entire application as described above, or may be a plug-in program that adds the sound control function described above to the application.

### [2-4. Exemplary Processing by Information Processing Apparatus]

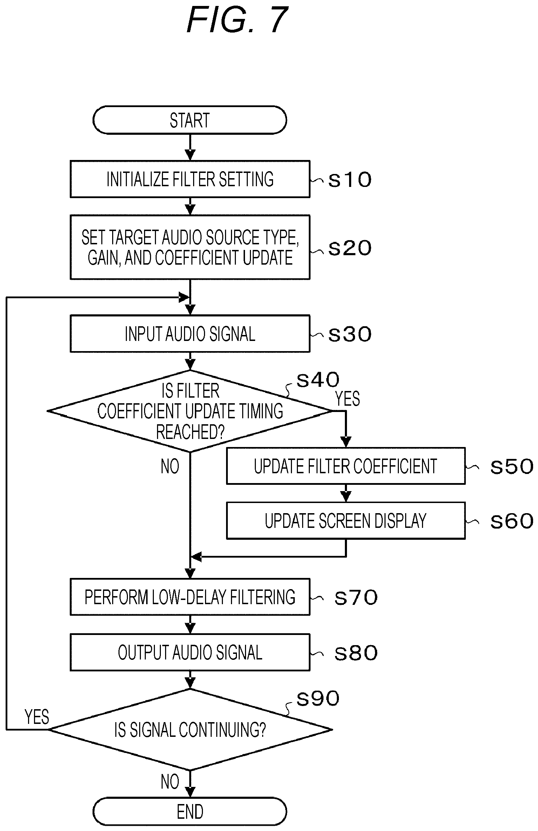

Fig. 7 illustrates the series of processing described above (sound quality adjustment process) as a flowchart. Note that, in the present example, it is described that each setting of the target audio source type, the gain, and the coefficient update to be the input based on the user operation described above is set only once at the beginning to make the flow easier to understand. However, this setting change may be made at any time.

When the sound quality adjustment process starts, the information processing apparatus 10 first initializes the setting of the filter processing unit 11 (step S10). Specifically, the coefficient update unit 16 sets an initial value to the filter coefficient. Then, when the sound quality adjustment setting is made according to a user operation, the information processing apparatus 10 sets the target audio source type, the gain, and the coefficient update (step S20). Specifically, the setting is instructed through the setting instruction screen illustrated in Fig. 2 to save the target audio source type, the gain, and the coefficient update in the storage area.

Then, the information processing apparatus 10 inputs audio signals after those settings are made (step S30). With this arrangement, the audio signals (input signals) are input to the filter processing unit 11, the audio source separation unit 13, and the coefficient update unit 16. Next, the information processing apparatus 10 determines whether or not the filter coefficient update timing is reached (step S40). Specifically, this determination is made by the coefficient update unit 16 on the basis of the coefficient update setting described above. In a case where the update timing is determined to be reached (YES) in step S40, the information processing apparatus 10 updates the filter coefficient (step S50). Specifically, the coefficient update unit 16 updates the filter coefficient using a calculation result of a filter coefficient calculation process (to be described later).

Next, the information processing apparatus 10 updates the screen display according to the update of the filter coefficient (step S60). Specifically, the screen display update unit 17 causes the display device to output information indicating a difference between before and after the update (e.g., image of the equalizer 3 as illustrated in Fig. 3).

After the update of the screen display in step S60, or in a case where the filter coefficient update timing is determined not to be reached (NO) in step S40, the information processing apparatus 10 performs low-delay filtering (step S70), and outputs filtered audio signals (step S80). Specifically, the filter processing unit 11 performs filtering on the audio signals, and outputs the filtered audio signals. Then, the output audio signals are transmitted to an output device such as a speaker or a headphone, and are output.

Next, the information processing apparatus 10 determines whether or not the signals are continuing (step S90), and the process returns to step S30 in a case where it is determined to be continuing (YES). On the other hand, in a case where it is not determined to be continuing (NO), the sound quality adjustment process is terminated.

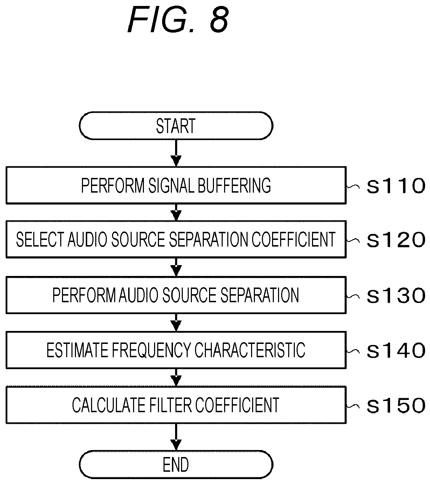

Fig. 8 is a flowchart illustrating a flow of the filter coefficient calculation process performed by the information processing apparatus 10. The filter coefficient calculation process starts when, for example, an audio signal is input to the audio source separation unit 13. First, the information processing apparatus 10 performs signal buffering on the audio signal (step S110). Next, the information processing apparatus 10 selects an audio source separation coefficient (step S120). Specifically, the audio source separation coefficient selection unit 12 selects the audio source separation coefficient on the basis of the set target audio source type, and outputs it to the audio source separation unit 13.

Subsequently, the information processing apparatus 10 performs audio source separation on the audio signal (step S130). Specifically, the audio source separation unit 13 separates the sound of the target audio source type from the audio signal on the basis of the audio source separation coefficient, and outputs it to the frequency characteristic estimation unit 14. Next, the information processing apparatus 10 estimates a frequency characteristic (step S140). Specifically, the frequency characteristic estimation unit 14 estimates the frequency characteristic of the separated sound of the target audio source type, and outputs it to the filter coefficient calculation unit. Finally, the information processing apparatus 10 calculates a filter coefficient (step S150), and terminates the filter coefficient calculation process. Specifically, the filter coefficient calculation unit 15 calculates a filter coefficient using the estimated frequency characteristic, and outputs it to the coefficient update unit 16. This filter coefficient is used for the update of the filter coefficient described above (step S50).

### [2-5. Conclusion]

In the information processing apparatus 10 according to the present embodiment, the coefficient update unit 16 determines the setting of filtering of the filter processing unit 11 that performs filtering on input signals using the estimation result obtained from the input signals by the estimation algorithm to control the sound of the target audio source type in the input signals. With this arrangement, it becomes possible to generate an optimal filter according to an input signal without requiring additional hardware such as a microphone. More specifically, a filter optimal for the characteristics of the sound of the target audio source type included in the input signals may be generated. With this arrangement, it becomes possible to reproduce signals having optimal acoustic characteristics for the user.

Furthermore, since the filtering in the filter processing unit 11 has a lower delay (specifically, real-time processing) than the processing of the estimation algorithm, output signals filtered by the filter processing unit 11 may be output with a low delay (e.g., delay of approximately several hundred microseconds to several milliseconds). Furthermore, since the setting of the filtering is automatically updated according to the coefficient update setting, the user is not required to finely adjust the setting of the filtering (specifically, equalizer, etc.).

Moreover, the setting of the filtering may be updated not only at regular intervals but also at timing when an instruction to change the setting of the filtering is received (optional timing of the user) or at timing that does not give the user discomfort. With this arrangement, it becomes possible to make a change in the sound quality at the time of filter coefficient update more natural, and not to impair a sense of immersion in the content.

Furthermore, in a case where the filter coefficient is updated by the coefficient update unit 16, the display device is caused to output the image of the user-operable equalizer so that the difference between before and after the update may be understood, whereby it becomes possible to allow the user to intuitively grasp the filter condition.

### <3. Second Embodiment>

An information processing apparatus according to a second embodiment is different from the information processing apparatus 10 according to the first embodiment in that a filter coefficient itself is estimated by an estimation algorithm. Other points (specific example of an application, configuration example of hardware, etc.) are basically the same as those of the information processing apparatus 10. Hereinafter, differences from the information processing apparatus 10 described above will be described.

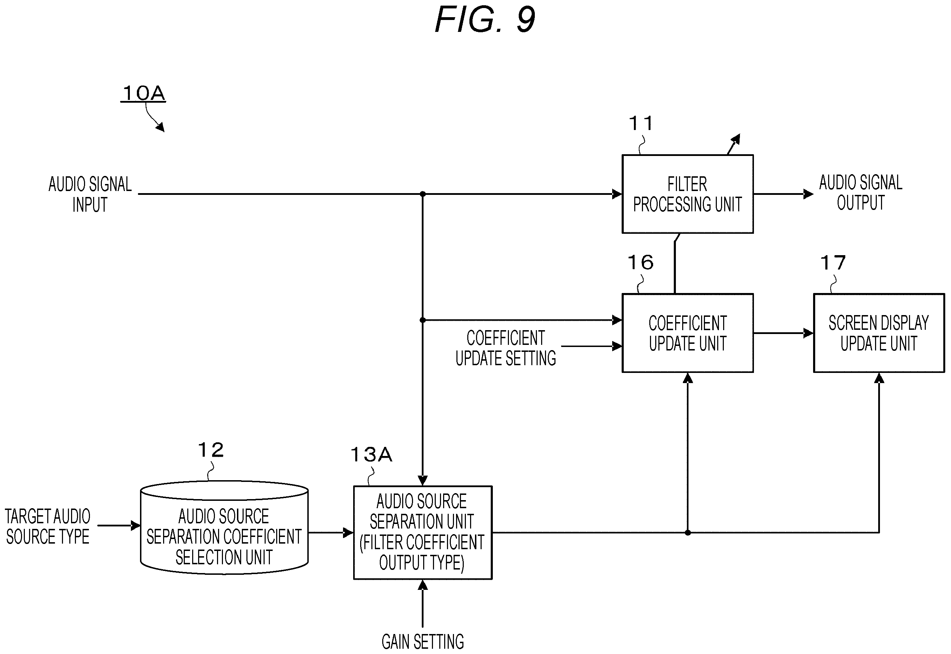

Fig. 9 illustrates a configuration example of functional blocks of the information processing apparatus (information processing apparatus 10A) according to the present embodiment. The information processing apparatus 10A includes a filter processing unit 11, an audio source separation coefficient selection unit 12, an audio source separation unit 13A, a coefficient update unit 16, and a screen display update unit 17.

The audio source separation unit 13A performs audio source separation process of a filter coefficient output type. To put it simply, the audio source separation unit 13A does not set an amplitude spectrum value as output, and directly estimates the filtering setting (specifically, filter coefficient) itself in the filter processing unit 11. An estimation algorithm regarding the audio source separation is used for the audio source separation processing. Specifically, the estimation algorithm estimates a filter coefficient from an input signal using the coefficient input from the audio source separation coefficient selection unit 12 and the set gain setting, and outputs it as an estimation result. For example, a neural network may be used as the estimation algorithm. Note that the estimation algorithm may be other than this as long as similar processing can be performed.

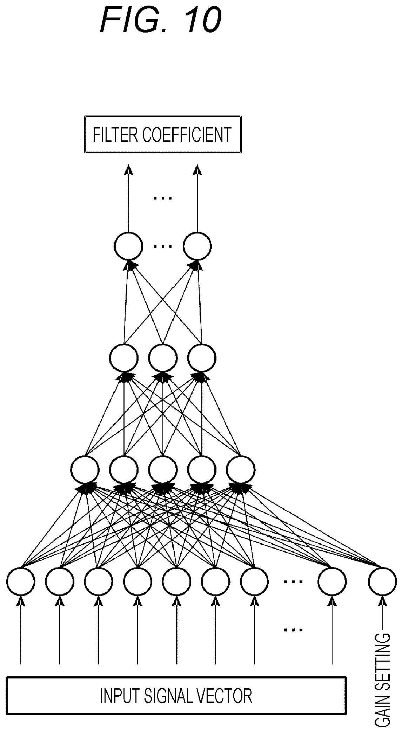

Fig. 10 illustrates an example of the filter coefficient calculation by the neural network. In a similar manner to the case of the exemplary audio source separation in Fig. 5 already described in the first embodiment, this neural network uses an amplitude spectrum obtained by converting an input signal into a frequency domain as an input signal vector. In addition, a value of the gain setting (e.g., +o dB, -o dB, etc.) is given as an input. An output of the neural network is set as a filter coefficient to be used by the filter processing unit 11. Since the neural network is enabled to carry out training as long as a set of input data and output data is prepared in advance, such anomalous input/output may also be implemented. The filter coefficient obtained in this manner is output to the coefficient update unit 16 and the screen display update unit 17.

The coefficient update unit 16 updates the filter coefficient of the filter processing unit 11 using the filter coefficient input from the audio source separation unit 13A. The screen display update unit 17 updates display of a display device using the filter coefficient input from the audio source separation unit 13A. Other points are similar to those of the first embodiment. In this manner, in the present embodiment, the process from the audio source separation (step S130) to the filter coefficient calculation (step S150) in the filter coefficient calculation process (see Fig. 8) by the information processing apparatus 10 according to the first embodiment is collectively performed in the audio source separation unit 13A. Other points are as described with reference to Figs. 7 and 8.

Therefore, according to the present embodiment, the following effects are exerted in addition to the effects described in the first embodiment. By directly outputting the filter coefficient itself in the audio source separation unit 13A, it becomes possible to omit the frequency characteristic estimation unit 14 and the filter coefficient calculation unit 15 (see Fig. 4) included in the information processing apparatus 10 according to the first embodiment. That is, it becomes possible to simplify the process by reducing the number of functional blocks.

Furthermore, the operation of the neural network itself may also reduce the number of dimensions of the output vector. Specifically, while a size of 1,024 or 2,048 is required in the case of the output of the amplitude spectrum, the output of the IIR filter coefficient requires a size of several to dozens. Accordingly, it becomes possible to reduce multiplication/addition operations in the subsequent stage of the neural network. Therefore, it becomes possible to reduce the calculation amount, that is, to reduce the power consumption, as compared with the case illustrated in Fig. 5 (case of outputting separated sound).

### <4. Third Embodiment>

An information processing apparatus according to a third embodiment is different from the first embodiment in that a filter coefficient is calculated by correcting a frequency characteristic according to an output device. Other points are similar to those of the first embodiment.

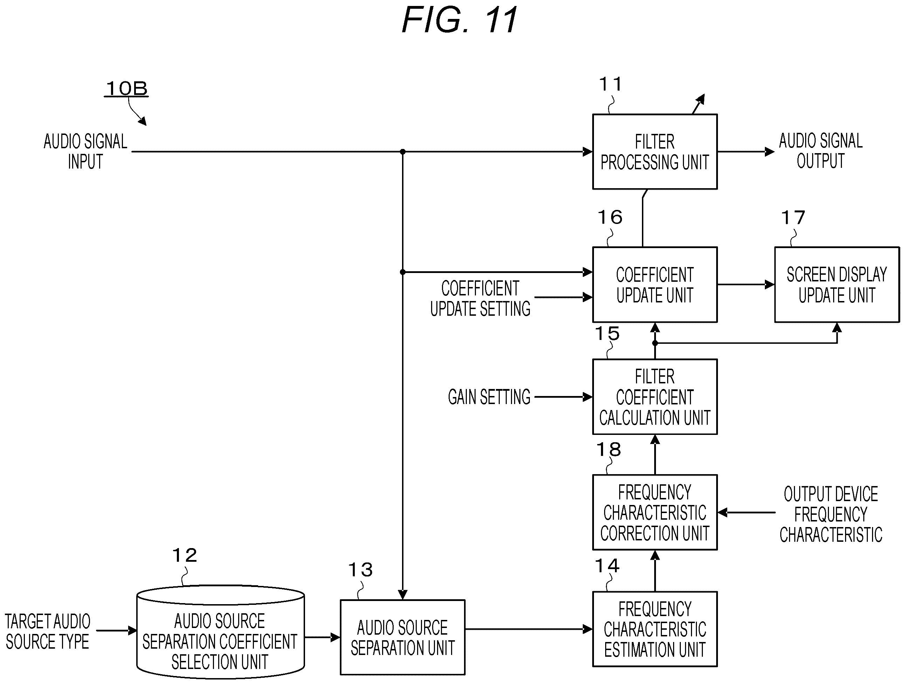

Fig. 11 illustrates a configuration example of functional blocks of the information processing apparatus (information processing apparatus 10B) according to the present embodiment. In a similar manner to the information processing apparatus 10 according to the first embodiment, the information processing apparatus 10B includes a filter processing unit 11, an audio source separation coefficient selection unit 12, an audio source separation unit 13, a frequency characteristic estimation unit 14, a filter coefficient calculation unit 15, a coefficient update unit 16, and a screen display update unit 17.

Furthermore, the information processing apparatus 10B includes a frequency characteristic correction unit 18 that performs the correction described above between the frequency characteristic estimation unit 14 and the filter coefficient calculation unit 15. That is, in the present embodiment, the frequency characteristic estimated by the frequency characteristic estimation unit 14 is output to the frequency characteristic correction unit 18.

The frequency characteristic correction unit 18 corrects the frequency characteristic estimated from the audio source separation output using the output device frequency characteristic. The output device frequency characteristic is a frequency characteristic unique to hardware of an output device (e.g., reproduction device such as headphone and speaker) that outputs filtered output signals. The output device frequency characteristic is, for example, measured and stored in a storage area in a readable manner in advance. For example, in a case where a use model of the output device is determined, the characteristic of the model is stored, and in a case of not being determined, the frequency characteristic of each model (e.g., speaker of a smartphone A, headphone B, etc.) is stored. Then, the model is determined (irrespective of whether it is determined automatically or manually) as necessary, and the characteristic according to the determination result is used.

Specifically, in view of the fact that the characteristic of the output device is applied at the time of reproduction, the frequency characteristic correction unit 18 performs correction by applying the negative characteristic thereof to the frequency characteristic of the audio source separation output. For example, while it may be difficult to output a low-pitched sound depending on the model of the output device, correction is performed to make the low-pitched sound easier to be output in that case. With this arrangement, it becomes possible to obtain a filter coefficient optimal for the output device.

Note that, while the frequency characteristic correction unit 18 corrects the frequency characteristic input from the frequency characteristic estimation unit 14 and outputs the corrected frequency characteristic to the filter coefficient calculation unit 15 in the illustrated example, the frequency characteristic estimation unit 14 may read the output device frequency characteristic and directly estimate the corrected frequency characteristic.

As described above, according to the present embodiment, the following effects are exerted in addition to the effects described in the first embodiment. It becomes possible to generate a more optimal filter according to the input signal and the output device frequency characteristic. That is, the sound quality is adjusted in consideration of both the content and the reproduction device, whereby sound with higher sound quality may be provided.

### <5. Fourth Embodiment>

An information processing apparatus according to a fourth embodiment is different from the first embodiment in that a part of a process is executed on a server side. Other points are similar to those of the first embodiment.

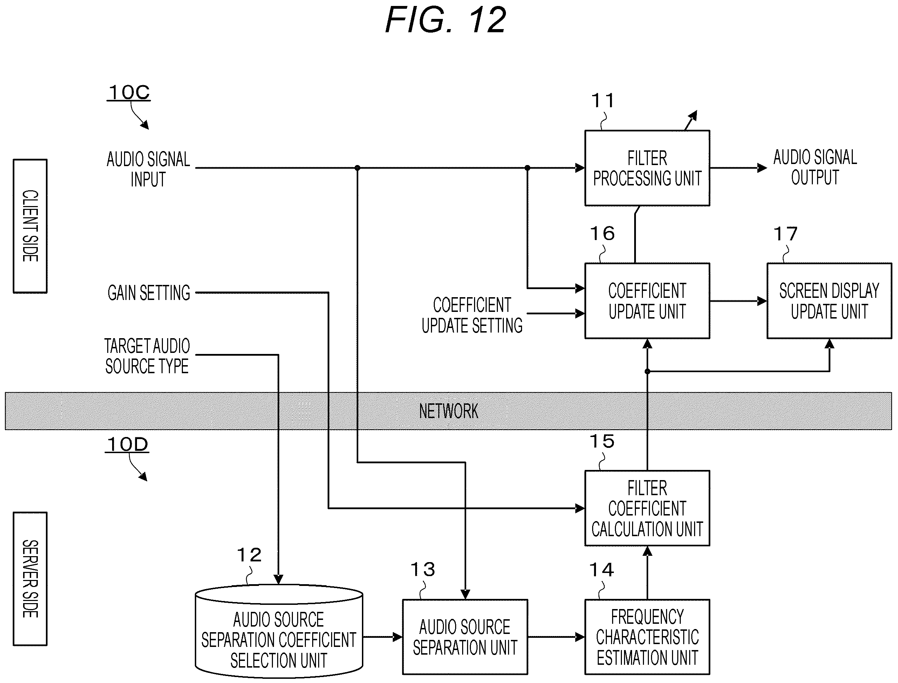

Fig. 12 illustrates a configuration example of functional blocks of the information processing apparatus (information processing apparatus 10C) according to the present embodiment. The information processing apparatus 10C to be on a client side includes a filter processing unit 11, a coefficient update unit 16, and a screen display update unit 17. Furthermore, the information processing apparatus 10C has a communication function capable of communicating with another information processing apparatus 10D to be on the server side via a network such as the Internet.

Meanwhile, the another information processing apparatus 10D includes an audio source separation coefficient selection unit 12, an audio source separation unit 13, a frequency characteristic estimation unit 14, and a filter coefficient calculation unit 15. Furthermore, the another information processing apparatus 10D has a communication function capable of communicating with the information processing apparatus 10C via a network. As described above, in the present embodiment, processing (specifically, filter coefficient calculation process illustrated in Fig. 8) of the audio source separation coefficient selection unit 12, the audio source separation unit 13, the frequency characteristic estimation unit 14, and the filter coefficient calculation unit 15 is performed on the server side. Note that a hardware configuration of the another information processing apparatus 10D is similar to that of the information processing apparatus 10C (see Fig. 6).

Specifically, the information processing apparatus 10C transmits input signals and a specified target audio source type and gain setting to the another information processing apparatus 10D. The another information processing apparatus 10D uses them to calculate a filter coefficient with the audio source separation coefficient selection unit 12, the audio source separation unit 13, the frequency characteristic estimation unit 14, and the filter coefficient calculation unit 15, and transmits the calculated filter coefficient to the information processing apparatus 10C.

The information processing apparatus 10C receives the filter coefficient transmitted from the another information processing apparatus 10D. Specifically, each of the coefficient update unit 16 and the screen display update unit 17 performs the process described above using the received filter coefficient. In this manner, the information processing apparatus 10C obtains the filter coefficient determined by the another information processing apparatus 10D via the network.

Therefore, according to the present embodiment, the following effects are exerted in addition to the effects described in the first embodiment. The information processing apparatus 10C on the client side transmits the input signals and various settings to be used for the sound quality adjustment to the another information processing apparatus 10D on the server side, and receives the filter coefficient from the another information processing apparatus 10D, whereby it becomes possible to obtain a filter coefficient with a low delay, low calculation amount, and high performance. That is, by executing the processing (specifically, audio source separation) with a relatively large calculation amount on the server side, it becomes possible to significantly suppress the calculation load on the client side.

### <6. Variations>

Although the embodiments of the present disclosure have been specifically described, the present disclosure is not limited to the above-described embodiments, and various modifications based on the technical idea of the present disclosure may be made. For example, various modifications to be described below may be made. Furthermore, one or a plurality of optionally selected aspects of the modifications to be described below may be appropriately combined. Furthermore, configurations, methods, processes, shapes, materials, numerical values, and the like of the above-described embodiments may be combined or exchanged with each other without departing from the gist of the present disclosure. Furthermore, one may be divided into two or more, and a part thereof may be omitted.

For example, while the above-described first embodiment exemplifies the configuration in which the setting of each of the target audio source type, the gain, and the coefficient update is set using the setting instruction screen illustrated in Fig. 2, the setting instruction is not limited to this. For example, the setting instruction screen may have another screen configuration. Specifically, the user instruction input unit 4 may be displayed separately from the game screen 2. Furthermore, the instruction of each setting is not limited to the instruction using the setting instruction screen, and may be, for example, an instruction issued by voice input. Moreover, each setting is not limited to a setting appropriately set by the user, and a predetermined setting may be used.

Furthermore, while the equalizer 3 illustrated in Fig. 2 is exemplified as an equalizer used for the sound quality adjustment in the first embodiment, for example, the applicable equalizer is not limited to this, and any equalizer (e.g., type, function, etc.) may be selected. In this case, it is sufficient if the setting items to be set by the user, the configuration of the filter processing unit 11, and the like are changed as necessary according to the equalizer to be used. For example, the equalizer 3 may be a graphic equalizer or a parametric equalizer, and the setting item may appropriately set the parameter of the equalizer to be used.

Furthermore, while the first embodiment exemplifies the configuration in which the sound of the target audio source type is amplified or attenuated, for example, the sound control is not limited to this. For example, the sound of the target audio source type may be extracted or removed, or the frequency characteristic (e.g., pitch) of the sound of the target audio source type may be changed. For example, by setting a sound of a specific person, a sound of a specific musical instrument, noise, and the like as the target audio source type, it may be applied to emphasize, change, extract, or remove those sounds.

Furthermore, while the first embodiment exemplifies the game as a specific example of the application to which the sound quality adjustment function of the information processing apparatus 10 is applicable, for example, it is not limited to this, and may be applied to other applications such as a web conferencing system, a live streaming system, and a calling application.

Furthermore, while the function of correcting the frequency characteristic of the output device (frequency characteristic correction unit 18) is provided to the information processing apparatus 10B including the audio source separation unit 13 described in the first embodiment in the third embodiment described above, for example, the function may be provided to the information processing apparatus including the audio source separation unit 13A described in the second embodiment. In this case, it is sufficient if, for example, the output device frequency characteristic is input to the audio source separation unit 13A in a similar manner to the gain setting illustrated in Fig. 5 to obtain the estimation result.

Furthermore, while the processing of the audio source separation coefficient selection unit 12, the audio source separation unit 13, the frequency characteristic estimation unit 14, and the filter coefficient calculation unit 15 described in the first embodiment is performed on the server side in the fourth embodiment described above, for example, the processing to be performed on the server side is not limited to this. For example, in the information processing apparatus 10A according to the second embodiment, the processing of the audio source separation coefficient selection unit 12 and the audio source separation unit 13A may be performed on the server side. Furthermore, a part of those processes may be performed on the server side, for example.

Note that the present disclosure may also adopt the following configurations.
(1) An information processing apparatus including:
   a filter processing unit that performs filtering on an input signal; and
   a filter setting unit that makes a setting of the filtering such that a sound of a target audio source type in the input signal is controlled and the setting is determined using an estimation result obtained from the input signal by an estimation algorithm.
(2) The information processing apparatus according to (1), in which
   the filtering is processing with a lower delay than the estimation algorithm.
(3) The information processing apparatus according (1) or (2), in which
   the filtering is real-time processing.
(4) The information processing apparatus according to any one of (1) to (3), in which
   the estimation algorithm estimates and separates the sound of the target audio source type from the input signal, and
   the setting of the filtering is determined on the basis of a frequency characteristic of the sound of the target audio source type separated by the estimation algorithm.
(5) The information processing apparatus according to any one of (1) to (3), in which
   the estimation algorithm directly estimates the setting of the filtering.
(6) The information processing apparatus according to any one of (1) to (5), in which
   the setting of the filtering amplifies or attenuates each frequency band of the input signal as appropriate such that the sound of the target audio source type is amplified or attenuated.
(7) The information processing apparatus according to any one of (1) to (6), in which
   the filtering is performed using an infinite impulse response (IIR) filter, and
   the setting of the filtering includes a filter coefficient of the filter.
(8) The information processing apparatus according to any one of (1) to (7), in which
   the estimation algorithm uses a neural network trained to obtain the estimation result by inputting an input signal for training.
(9) The information processing apparatus according to any one of (1) to (8), in which
   the setting of the filtering is updated at timing when an instruction for the filtering is received, at a regular interval, or at timing when no discomfort is determined on the basis of predetermined determination information.
(10) The information processing apparatus according to any one of (1) to (9), in which
   in a case where the setting of the filtering is updated, an output device is caused to output information indicating a difference between before and after the update.
(11) The information processing apparatus according to any one of (1) to (10), in which
   the output device is a display device, and
   the output device is caused to display an image of a user-operable equalizer including the information indicating the difference.
(12) The information processing apparatus according to any one of (1) to (11), in which
   the setting of the filtering is corrected according to a frequency characteristic of an output device that outputs an output signal after the filtering.
(13) The information processing apparatus according to any one of (1) to (12), in which
   the setting of the filtering is determined by another information processing apparatus and obtained via a network.
(14) An information processing method including:
   determining a setting of filtering of a filter processing unit that performs the filtering on an input signal using an estimation result obtained from the input signal by an estimation algorithm to control a sound of a target audio source type in the input signal.
(15) A program for causing a computer to perform a process including:
   determining a setting of filtering of a filter processing unit that performs the filtering on an input signal using an estimation result obtained from the input signal by an estimation algorithm to control a sound of a target audio source type in the input signal.

### REFERENCE SIGNS LIST

- 3: Equalizer
- 10, 10A, 10B, 10C: Information processing apparatus
- 11: Filter processing unit
- 13, 13A: Audio source separation unit
- 14: Frequency characteristic estimation unit
- 15: Filter coefficient calculation unit
- 16: Coefficient update unit
- 17: Screen display update unit
- 18: Frequency characteristic correction unit

## Claims

1. An information processing apparatus comprising:
a filter processing unit that performs filtering on an input signal; and
a filter setting unit that makes a setting of the filtering such that a sound of a target audio source type in the input signal is controlled and the setting is determined using an estimation result obtained from the input signal by an estimation algorithm.

2. The information processing apparatus according to claim 1, wherein
the filtering includes processing with a lower delay than the estimation algorithm.

3. The information processing apparatus according to claim 1, wherein
the filtering includes real-time processing.

4. The information processing apparatus according to claim 1, wherein
the estimation algorithm estimates and separates the sound of the target audio source type from the input signal, and
the setting of the filtering is determined on a basis of a frequency characteristic of the sound of the target audio source type separated by the estimation algorithm.

5. The information processing apparatus according to claim 1, wherein
the estimation algorithm directly estimates the setting of the filtering.

6. The information processing apparatus according to claim 1, wherein
the setting of the filtering amplifies or attenuates each frequency band of the input signal as appropriate such that the sound of the target audio source type is amplified or attenuated.

7. The information processing apparatus according to claim 1, wherein
the filtering is performed using an infinite impulse response (IIR) filter, and
the setting of the filtering includes a filter coefficient of the filter.

8. The information processing apparatus according to claim 1, wherein
the estimation algorithm uses a neural network trained to obtain the estimation result by inputting an input signal for training.

9. The information processing apparatus according to claim 1, wherein
the setting of the filtering is updated at timing when an instruction for the filtering is received, at a regular interval, or at timing when no discomfort is determined on a basis of predetermined determination information.

10. The information processing apparatus according to claim 1, wherein
in a case where the setting of the filtering is updated, an output device is caused to output information indicating a difference between before and after the update.

11. The information processing apparatus according to claim 10, wherein
the output device includes a display device, and
the output device is caused to display an image of a user-operable equalizer including the information indicating the difference.

12. The information processing apparatus according to claim 1, wherein
the setting of the filtering is corrected according to a frequency characteristic of an output device that outputs an output signal after the filtering.

13. The information processing apparatus according to claim 1, wherein
the setting of the filtering is determined by another information processing apparatus and obtained via a network.

14. An information processing method comprising:
determining a setting of filtering of a filter processing unit that performs the filtering on an input signal using an estimation result obtained from the input signal by an estimation algorithm to control a sound of a target audio source type in the input signal.

15. A program for causing a computer to perform a process comprising:
determining a setting of filtering of a filter processing unit that performs the filtering on an input signal using an estimation result obtained from the input signal by an estimation algorithm to control a sound of a target audio source type in the input signal.
